# EUROPEAN PATENT SPECIFICATION

(11) **EP 3 563 456 B1**
(45) Date of publication and mention of the grant of the patent: **21.10.2026**
(21) Application number: 17816638.5
(22) Date of filing: 07.12.2017
(51) Int. Cl.: H02G 3/22

(54) **FEEDTHROUGH DEVICE AND SIGNAL CONDUCTOR PATH ARRANGEMENT**
DURCHFÜHRUNGSVORRICHTUNG UND SIGNALLEITERBAHNANORDNUNG
DISPOSITIF DE TRAVERSÉE ET AGENCEMENT DE TRAJET DE CONDUCTEURS DE SIGNAUX

(30) Priority: 27.12.2016 US 201615390777
(43) Date of publication of application: 06.11.2019
(73) Proprietor: ASML Netherlands B.V., 5500 AH Veldhoven (NL)
(72) Inventor: SPRENGERS, Johannes Petrus, 5500 AH, Veldhoven (NL); OTTEN, Christiaan, 5500 AH, Veldhoven (NL)
(74) Representative: ASML Netherlands B.V.
(86) International application number: PCT/EP2017/081831
(87) International publication number: WO 2018/121969

(56) References cited:
- EP-A1- 0 096 914
- EP-A1- 1 936 750
- WO-A1-2007/118515
- WO-A1-2010/094719
- WO-A1-98/09489
- CN-A- 103 791 965
- CN-B- 102 705 590
- DE-A1- 10 310 070
- DE-A1- 3 720 061
- US-A- 5 491 300
- US-A1- 2010 157 552
- US-A1- 2013 248 245

## Description

### Technical Field

The invention relates to a feedthrough device, to a signal conductor path arrangement including at least one such feedthrough device, and to a vacuum chamber and a processing system including such signal conductor path arrangement, wherein the signal conductors encompass for example optical fibers and electrical conductors, among which electrical conductors arranged in a printed circuit board.

### Background Art

In semiconductor industry, including various types of semiconductor processing and manufacturing devices, an ever-increasing desire exists to manufacture smaller structures with high accuracy and reliability. Lithography is often a critical part of such manufacturing processes. During lithography exposure or other types of processing, the target (e.g. a semiconductor wafer) may need to be situated in a high vacuum environment that is hermetically sealed from the surroundings (e.g. from atmospheric conditions), to reduce the probability of contamination.

In the particular case where such vacuum environment is applied for operating a mask-less lithography system, charged particle beamlets may be used to transfer a pattern onto the target. The beamlets may be individually controllable to obtain the desired pattern. To be commercially viable, mask-less lithography systems need to meet challenging demands for wafer throughput and error margins. A higher throughput may be obtained by using more beamlets. The handling of a greater number of beamlets calls for more sophisticated control devices and circuitry, without compromising the necessary vacuum conditions or significantly increasing the required fab space (i.e. the area covered by the processing unit). The task of arranging more process control devices and/or circuitry in a decreasing available volume while maintaining hermetic seals between various parts of the lithography system becomes more and more challenging.

For the control of the lithography systems, including control of a large number of beamlets for exposing the target as well as various other control devices and circuitry, various types of signals, encompassing power supply signals, various electrical signals, and/or optical signals, have to be transmitted or passed through the boundary of the vacuum environment.

In relation to the technological subject of feedthrough of either signals or electric power from one environment or compartment to another, the publication "Hermetic Sealing with Epoxy" of W.D. Wood and W.L. Wood, Mechanical Engineering Vol. 112, March 1990, p. 46 (http://www.pavetechnologyco.com/pdf/hermetic.pdf), describes this as a long standing basic and generic technology, using glass or ceramic filled metal housings. The publication also describes a major development in this technology by the application of epoxy based sealing in bulk heads and other type of signal or power feedthrough from the early 1980's. The publication indicates that epoxy sealing provides good vacuum sealing in combination with various materials used in and/or around electrical conductors, including aluminum as widely used for creating vacuum environments, and copper as widely used for conveying electric signals, as well as various insulating materials. It is further indicated that epoxy seals comply with cleanliness requirements making them suitable for use in vacuum wafer-handling systems.

From the teaching of the article of Wood and Wood it may hence be concluded that epoxy sealing can be expected to be applicable also for hermetically sealing printed circuit boards (PCB) in an electrical feedthrough.

An example of such known type of PCB feedthrough using a bulkhead in combination with an O-ring is provided by patent document US6305975B1, which describes the feed through of a PCB permanently encapsulated in an epoxy based bulkhead. The PCB with bulkhead may in principle be formed as the cover for a cylindrically shaped opening of a low pressure chamber, and is at its perimeter sealed to the opening using an O-ring type of vacuum seal.

Patent document US7164142B2 shows examples of vacuum feedthrough including the known face type sealing. A structure for an electrical feedthrough is described, utilizing a sheet of insulating material including at least one embedded layer of conductive tracks, where the sheet face is sealed to the vacuum wall using a fillet of sealing material. PCB is indicated to form an example of such insulating material comprising a plurality of conductive tracks.

While the latter mentioned feedthrough of US7164142B2 merely seems to provide for permanent sealing of a PCB feedthrough, the older, in 2001 published patent US630597B1 forms a more versatile design, providing a releasable PCB feedthrough connector.

Patent document US8242467B2, assigned to the current applicant, discloses a multi-beamlet lithography system. This system comprises a beamlet blanker (or modulator) for selectively allowing or denying individual beamlets passage to the target, based on pattern data. The beamlet blanker is arranged near the target in a vacuum chamber, but controlled by a control unit that is located outside the vacuum chamber. The lithography system includes an optic system with an array of optical fibers for transmitting modulated light signals with the pattern data from the control unit to light sensitive blanking actuators on the beamlet blanker. The fibers are routed via an opening in a feedthrough device through a wall of the vacuum chamber. Vacuum compatible sealing material is used to provide an airtight sealing for the fibers in the opening. US8242467B2 presents little details in relation to the structure of the feedthrough device.

Patent document US2016/0787599A1 describes fiber alignment assemblies for hermetically feeding optical fibers through a housing of an opto-electronic module. One such assembly includes a ferrule, with two adjoined ferrule portions. One ferrule portion has a surface with four alignment grooves, which accommodate end sections of optical fibers. The second ferrule portion covers the surface and the alignment grooves of the first ferrule portion, when the ferrule portions are mated together to form the ferrule. Sealant material, such as glass solder, may then be fed into the ferrule, through an aperture in one of the ferrule portions. Vacuum is applied to a pocket in the ferrule, to draw the glass solder through clearances between the optical fibers and grooves, to form a hermetic seal. The hermetic assemblies from US2016/0787599A1 are primarily suitable for feeding through relatively small numbers of individual optical fibers.

WO 98/09489 discloses a filler element which defines a slot to receive a signal conductor 64 and is supported on a circumferential ledge 28 in the exterior wall 23 of a housing 12. A sealant 54 seals the signal conductor to the filler element which is separately sealed to the housing member. US2010/157552A1 and US5491300A both disclose signal conductor path arrangements with hermetically sealed feedthrough devices for a plurality of signal conductors where the conductors pass through a slotted member held by a base and sealed by a sealing body made of a sealant cast into a receptacle.

It would be desirable to provide a feedthrough device that is suitable for routing a large number of signal conductors, such as optical fibers (i.e. several tens or hundreds) or electrical conductors, for example provided in printed circuit boards, in an ordered and hermetically sealed manner through a structure that separates two regions with different ambient conditions.

It is also desirable to provide vacuum feedthrough devices which allow for reliability, versatility and repeatability in a contemporary industrial design.

### Summary of Invention

According to a first aspect of the invention, there is provided a signal conductor path arrangement as recited in claim 1 and its dependent claims.

The signal conductors extend along each other to form a signal conductor group with a group width. The feedthrough device comprises a slotted member and a base. The slotted member defines, in fact is delimited by, a first surface that faces predominantly towards a feedthrough direction, a second surface that faces predominantly opposite to the feedthrough direction, and a side surface that interconnects the first and second surfaces and faces outwards in a direction non-parallel to the feedthrough direction, for example at an oblique angle or transverse to the feedthrough direction. The base defines a hole that extends entirely through the base along the feedthrough direction, this hole being adapted to accommodate the slotted member. The base defines an inner surface that directly surrounds the hole. The base is adapted to accommodate at least part of the slotted member inside the hole, in such a way that the inner surface covers at least part of the side surface and the longitudinal opening of the slotted member. The slotted member includes at least one slot, which extends along the feedthrough direction through the slotted member, and opens into the first and second surfaces, to allow the signal conductor group to pass from the first surface through the slotted member to the second surface. The slot further opens into a longitudinal opening, which extends along the side surface. The slot extends from the side surface along a depth direction transverse to the feedthrough direction up to a slot depth into the slotted member. This slot depth is equal to or larger than the group width.

The signal conductors may comprise any type of substance or body capable of transmitting energy and/or information, generally in the form of light or electricity. Typical examples of signal conductors encompassed by the present invention are optical fibers, for transmitting light signals, and electrical conductors, for transmitting electrical signals, for example in the form of printed circuit boards (PCB's) comprising a plurality of electrical conductors.
The individual signal conductors forming the signal conductor group are not necessarily arranged abutting one another, but can be arranged at a distance from one another. The signal conductors may be arranged in a material or substance, and/or arranged on a surface, such as to be spaced from one another. The group width is defined as the width of the group of signal conductors, where the signal conductors are arranged abutting one another or at a distance from one another. When the signal conductors are provided as electrical conductors in a PCB, the group width is defined by the width of the PCB.

A hermetic seal is an airtight seal, in particular when subject to large pressure differences such as in vacuum applications. The feedthrough device in particular forms a vacuum feedthrough device, suitable for high vacuum applications.

The signal conductors extend co-directionally and alongside each other, to form the signal conductor group. The signal conductor group is preferably substantially flat. The signal conductors in the group may directly abut, or may have some spacing in between. When the signal conductors comprise optical fibers, the optical fiber groups may be arranged in the form of ribbons. When the signal conductors comprise electrical conductors, these may form part of a printed circuit board.

The slot forms a narrow groove that extends from the longitudinal opening at the side surface, inwards into the slotted member, and allows a longitudinal portion of the associated signal conductor group to be easily and reliably inserted into the slotted member during manufacturing of a signal conductor path arrangement. The transverse extent of the slot into the slotted member allows the signal conductor group, which preferably is flat, to be inserted sideways into the slotted member, while leaving a large part of the periphery of the slotted member available for other slots and signal conductor groups. The slot depth is at least equal to the group width, but may be larger in order to provide additional slot space. When the signal conductors comprise an optical fiber group, this excess slot space may for example be used to insert a retaining wire or strip next to the fiber group into the slot, to block the longitudinal opening and hold the fiber group inside the slot. The proposed arrangement of flat signal conductor groups and slots allows a large number of signal conductors (i.e. in the order of tens or hundreds or more) to be routed through the feedthrough device in a hermetically sealed and well-ordered manner.

The slotted member and base have thicknesses (or depths) defined along the feedthrough direction, and cross-sectional areas defined in planes transverse to the feedthrough direction. These dimensions may be adapted to meet specific requirements in relation to differential pressures and structural robustness. For example, the thicknesses of the slotted member and base may be in a range of 5 millimeters to 40 millimeters, and the cross-sectional area of the slotted member may in a range of 100 square millimeters to 1500 square millimeters.

Preferably, the slot has a predominantly rectangular shape, which extends transversely from the longitudinal opening inwards into the slotted member, along a linear trajectory with the slot depth. The slot may have a slot width in a width direction transverse to both the feedthrough direction and the depth direction, which is smaller than the slot depth along the entire depth extent of the slot. This slot width may remain constant along the entire depth extent of the slot. The slot may extend into the slotted member in a direction perpendicular to a local portion of the side surface that borders on the longitudinal opening.

The arrangement with a slotted member accommodated in and surrounded by a base, can be accurately aligned and is robust. The inner surface of the base covers the longitudinal opening(s) of the slot(s) in the assembled state of the device, and ensures that signal conductor groups are properly retained within their slot, before a sealing body is applied to the arrangement.

According to an embodiment, the first surface of the slotted member is recessed along the feedthrough direction relative to a surface of the base that directly surrounds the hole, when the slotted member is accommodated in the hole. In this embodiment the first surface of the slotted member is recessed to such an extent that at least the first surface of the slotted member and the inner surface of the base form a receptacle in which a sealing body can be accommodated.

The resulting receptacle forms a container that allows a sealing body to be formed, by pouring liquid sealant material into the receptacle, and letting this liquid sealant material cure. Gravitational pull may be exploited, to let the liquid sealant material distribute itself across the first surface of the slotted member and cover part of the slot(s) where the signal conductor group(s) exits the slot (s), to envelop part(s) of the signal conductor group(s) and provide a hermetic barrier. The liquid sealant material may thereby be drawn into the slot(s), possibly assisted by capillary action, so that the cured sealing body will extend along at least part of the slot(s) in the feedthrough direction. Space between the inner wall of a respective slot and the longitudinal portion of the associated signal conductor group will thus also become occupied by the sealing body, to yield an improved sealing effect. Such a sealing body covers the first surface of the slotted member and at least the part of the slot where a signal conductor group exits the slot, to envelop the signal conductor group and form a hermetic barrier between first and second regions that are outside the slotted member and border on the first and second surfaces of the slotted member, respectively.

This liquid sealant material may for example be a glue, adhesive or resin, for example an epoxy-based glue, adhesive or resin, that adheres to the first surface of the slotted member and to the inner surface of the base adjacent to the liquid sealant material. The viscosity of the uncured glue preferably is sufficiently low to allow the uncured glue to enter the slot(s) and locally envelop a portion of the signal conductor group, for example in the form of an optical fiber group or a printed circuit board, inside this slot, but also sufficiently high to prevent the liquid sealant material from flowing through the entire slot and via the second surface out of the slotted member. In the case that a maximum distance between an inner wall of a slot and an outer surface of a signal conductor within the group inside this slot is always below 0.5 mm, a viscosity in a range of 20 Pa·s to 50 Pa·s may be suitable.

According to embodiments, the side surface of the slotted member has a cross-sectional shape that resembles a stadium or a rounded rectangle. The inner surface of the base around the through hole may have a similar cross-sectional shape, which is adapted to accommodate the slotted member in a form-fitting manner.

A stadium and a rounded rectangle have linear edges and rounded edges, but omit sharp corners. Several manufacturing-related advantages may be obtained by forming the lateral outer and inner surfaces of the slotted member and base with similar cross-sectional shapes of the above-mentioned types. The finite rotational symmetry of such shapes facilitates alignment between the base and the slotted member. The linear edges provide regions in which slots are more easily formed in a mutually parallel and/or regularly distributed manner, which in turn facilitates insertion of fiber groups. Furthermore, the rounded edges promote equal distribution of liquid sealant material along the first surface and slot(s).

According to embodiments, the side surface of the slotted member defines a flat surface portion that extends in a translationally symmetric manner along a direction perpendicular to the feedthrough direction. The longitudinal opening may be located at this flat surface portion, and the at least one slot may extend perpendicular to the flat surface portion into the slotted member.

Forming of the slot(s) and insertion of the signal conductor group(s) in this slot(s) is facilitated by forming the slotted member with a flat side surface portion and with one or more slots that extend perpendicularly to this flat surface portion into the slotted member.

According to embodiments, the side surface of the slotted member defines a first side surface segment, which is inwardly tapered towards an axis along the feedthrough direction. In addition, the inner surface of the base may be inwardly tapered congruent to the first side surface segment.

This axis corresponds with coinciding central axes of the slotted member and the hole in the base. The inwards tapering implies that the first side surface segment is locally tilted to face partially laterally outwards and partially towards the feedthrough direction. Similarly, the inner surface of the base may be locally tilted to face partially inwards and partially towards the feedthrough direction. Due to the tapering, the slotted member and the hole in the base jointly decrease in size as a function of position along the feedthrough direction. This ensures that the slotted member will automatically find an optimal fitting position in the hole, after which it will be prevented from moving further though the base. Any excess pressure exerted on the first surface of the slotted member will keep the slotted member fixed inside the base. This is advantageous in operational setting wherein the outside pressure exceeds the pressure inside the vacuum chamber. The inwards tapering may extend along at least part of the transverse outer periphery of the slotted member and at least part of the transverse inner periphery of the base. In particular, the inwards tapering may extend along the entire outer and inner peripheries of the slotted member and base, respectively. The inwards peripheral tapering may extend along at least part of the thickness of the slotted member and the base, viewed along the feedthrough direction.

According to further embodiments, the side surface of the slotted member includes a second side surface segment. This second side surface segment is inwardly tapered, chamfered, or filleted towards the axis, but in an opposite manner with respect to the first side surface segment. Alternatively or in addition, the inner surface of the base may include an inner surface segment that is outwardly tapered, chamfered, or filleted away from the axis, such that the second side surface segment and/or inner surface segment define an inwards peripheral recess. This inwards peripheral recess directly borders on the at least one longitudinal opening in the slotted member, and is adapted to accommodate a portion of the sealing body.

The inward peripheral recess, defined by the tapered/chamfered/filleted second side surface segment of the slotted member and/or the tapered/chamfered/filleted inner surface of the base, directly surrounds the first surface of the slotted member and borders on the longitudinal opening(s) of the slot(s). The peripheral recess allows liquid sealant material to partly cover and be drawn into the longitudinal recess(es), in order to embed longitudinal portion(s) of the signal conductor group(s) inside the slot(s) within sealant material, and improve the hermetic seal provided by the feedthrough device. The inwards/outwards taper/chamfer/fillet may extend along at least part of the transverse outer periphery of the slotted member and at least part of the transverse inner periphery of the base. The tapered/chamfered/filleted regions may for example cover at least those surface regions where slots reside, or may alternatively extend around the entire transverse peripheries. The height of the taper/chamfer/fillet along the feedthrough direction is preferably limited to the region near the first surface of the slotted member.

According to embodiments, the slotted member and the base form rigid bodies that consist essentially of one or more solid materials.

The solid materials for the slotted member and the base preferably have no or negligible viscoelastic properties, at least in the typical operational temperatures and typical differential pressures between the first and second regions associated with the two hermetically sealed sides of the feedthrough device. The geometries of these bodies thus remain intact, even under varying pressure and temperature conditions. The solid materials are preferably selected from the group of metals or metal alloys that are solid at room temperature, and have low outgassing rates in vacuum. For example, the slotted member and the base may consist (essentially) of aluminum, in view of machinability and vacuum compatibility requirements. Other solid materials may be used for forming the slotted member and the base, and a suitable alternative adhesive material may be used that bonds to the surfaces of the slotted member and the base. The sealing body may be formed from liquid sealant material that adheres to the one or more solid materials and fixes the slotted member to the base, when cured.

According to embodiments, the plurality of signal conductors is provided as a plurality of optical fibers, a plurality of electrical conductors, and/or a plurality of electrical conductors in a printed circuit board (PCB). Such PCB comprises a plurality of electrical conductors integrated on and/or embedded within one or more layers of material. The PCB may be rigid and/or flexible. In some embodiments, the PCB comprises a central part comprising a plurality of electrical conductors, the central part to be arranged within the slot of the slotted member. The PCB may further comprise one or more distal parts, connected with the central portion and generally comprising one or more electrical components and connectors or terminals for connecting to conductors or wiring which are external of the PCB. The central portion may be flexible or rigid. The distal portions are generally rigid, although these might also be flexible.

According to a second aspect of the invention, and in accordance with the advantages and effects discussed herein above with reference to the first aspect, there is provided a signal conductor path arrangement including signal conductors, a feedthrough device according to the first aspect, and a sealing body. The slotted member is accommodated in the hole of the base. The signal conductors extend along each other to form a signal conductor group with a group width. The signal conductor group is arranged with a longitudinal portion inside the slot of the slotted member, in order to extend between the first and second surfaces of the slotted member through the feedthrough device. The sealing body covers the first surface of the slotted member and at least the part of the slot where the signal conductor group exits the slot, to envelop the signal conductor group and provide a hermetic barrier between first and second (distinct) regions, which are outside the slotted member and border on the first and second surfaces of the slotted member respectively.

The sealing body may be a thermosetting material. In one embodiment, it may comprise an epoxy based material, preferably a two-component epoxy e.g. comprising a modified amine hardener. Suitable candidates may be those that have low outgassing properties. The sealing body may also be distinguished over elastomer-based seals by its high hardness. Preferably, the sealing body has a Shore D hardness of greater than 50. The viscosity of uncured liquid sealant material is preferably sufficiently low to allow it to enter the slot(s) and locally envelop the signal conductor group inside this slot, but also sufficiently high to prevent the liquid sealant material from flowing through the entire slot and via the second surface out of the slotted member. In the case that a maximum distance between an inner wall of a slot and an outer surface of a signal conductor within the group inside this slot is always below 0.5 mm, a viscosity in a range of 20 Pa·s to 50 Pa·s may be suitable.

According to an embodiment, the signal conductor path arrangement comprises further signal conductors, which extend alongside each other in arrays to form further signal conductor groups with group widths. The slotted member may include further slots, which extend along the feedthrough direction through the slotted member and open into the first and second surfaces to allow the signal conductor groups to pass from the first surface through the slotted member to the second surface. Each slot may further open into a respective longitudinal opening along the side surface of the slotted member, and extend from the side surface up to a slot depth into the slotted member. The sealing body covers all slots to form the hermetic barrier.

The signal conductor path arrangement may thus route multiple groups of signal conductors, which are preferably substantially flat, via separate slots through the feedthrough device, while retaining all signal conductors in a well-defined spatial order. The signal conductor path arrangement may comprise one or more feedthrough devices.

The longitudinal openings may be provided on the same and/or on opposite flat surface portions of the side surface of the slotted member. A multitude of signal conductor groups is easier to insert into a plurality of slots, if the slots are located in such flat lateral surface portions.

According to an embodiment, the signal conductors have a signal conductor diameter Øf and are arranged alongside each other into a single-layered array, to form the signal conductor group with a group thickness that is at least equal to the signal conductor diameter but smaller than twice the signal conductor diameter. This applies in particular to embodiments where the signal conductors are optical fibers.

By arranging the signal conductors alongside into a single-layered array to form a flat signal conductor group, the ordering of the signal conductors, in particular optical fibers, within one group remains uniquely defined and clearly identifiable, even after longitudinal portions of the signal conductor groups have been enclosed in the slotted member and embedded within the sealing body after completion of the device. A grouping of signal conductors into a single-layered array implies that signal conductors, such as optical fibers, have at most two nearest neighbors within the signal conductor group. Formation of a two-dimensional stacking of signal conductors and 2D-enclosure of a void by the signal conductors is thus avoided. The axial centers of the signal conductors may have varying positions in a transverse (thickness) direction, to yield a group thickness Hf that exceeds the signal conductor diameter. For cylindrical optical fibers with circular outer cross-sections Øf, the group thickness Hf preferably stays within a range Øf ≤ Hf < 1,86·Øf.

According to a further embodiment, the slot has a slot width ΔYs transverse to both the feedthrough direction and the slot depth ΔZs, and the slot width ΔYs is within a range defined by Øf < ΔYs < 2·Øf, with Øf the outer diameter of the signal conductors.

By providing slots with a width ΔYs in the specified range, each flat single-layered group of signal conductors may be accommodated in an associated slot, while the slot prevents signal conductors of the same group from crossing each other and/or from forming a multi-layered array. Hence, the signal conductors stay in their predetermined spatial arrangement. Preferably, the slot width ΔYs is within a range Øf < ΔYs < 1.86·Øf, or more preferably within a range Øf < ΔYs < 1.5·Øf. The slot thus prevents signal conductors within the same group from forming a staggered dual-layered group of signal conductors. This is particularly advantageous when the signal conductors are provided as optical fibers.

According to embodiments, the slotted member and the base of the signal conductor path arrangement consist essentially of solid materials, and the signal conductors are coated on outer surfaces with a material that is essentially the same as the material of the slotted member. Alternatively, the signal conductors are coated with a material different from the material of the slotted member but to which the liquid sealant material also adheres. Adherence of the sealing material to the signal conductors, e.g., optical fibers, electrical conductors, or printed circuit board (PCB), contributes to the sealing properties of the feedthrough device.

The sealing body may then be formed from an adhesive-sealant material that is optimized for bonding to the coating on the outer surfaces of the signal conductors, e.g. coated optical fibers or a coated PCB, and the slotted member. The optical fibers may for example be coated with a solid metal, such as aluminum. Such a metal (e.g. aluminum) coating reduces outgassing of the fibers inside the vacuum chamber. The PCB, or at least a portion thereof which is to be in contact with the sealing body, may be coated with a solid metal, such as (galvanized) copper, providing good adhesion for a sealing body of the types described above.

According to embodiments, the signal conductor group comprises a first connector at a first end that is located in the first region (e.g. associated with the inside of a vacuum chamber), or a second connector at an opposite second end that is located in the second region (e.g. associated with the outside of a vacuum chamber), or connectors at both ends. Alternatively or in addition, further signal conductor groups may include similar connectors at one or both ends. The connectors may be grouped to form connector panels, to improve manageability and structural robustness of the signal conductor path arrangement. The first connector and/or the second connector may for example be multipole connectors.

The signal conductor path arrangement may include a panel onto which the one or more feedthrough devices are mounted. Such a panel may form a wall part that is sealingly attachable to and removable from a larger structure, like a wall of a vacuum chamber. The resulting modularity of the signal conductor path arrangement facilitates manufacturing and/or maintenance.

According to a third aspect, and in accordance with the advantages and effects discussed herein above with reference to the previous aspects, there is provided a vacuum chamber. The vacuum chamber comprises at least one wall and a signal conductor path arrangement in accordance with the second aspect, which is provided at or in the wall. The at least one group of signal conductors in the signal conductor path arrangement extends from a first region on one side of the wall, via the feedthrough device through the wall, to a second region on an opposite side of the wall.

According to a fourth aspect, and in accordance with the advantages and effects discussed herein above with reference to the previous aspects, there is provided a target processing system, which comprises a vacuum chamber according to the third aspect. The target processing system may be a lithography processing or exposure system, for example a charged particle beam lithography system or an electromagnetic beam lithography system.

According to an embodiment, the target processing system is configured to generate and project beams of radiation towards a target inside the vacuum chamber. The target processing system may comprise a beam switching module, which is arranged inside the vacuum chamber, and is configured to modulate and/or select beams for projection onto the target based on control signals. The signal conductor path arrangement may be adapted to transmit the control signals from a control unit external to the vacuum chamber, via the signal conductors that extend through the feedthrough device, to the beam switching module.

The slotted member, and its various features and advantages, may in and of itself be considered a further aspect of the invention.

The various embodiments described above may be combined.

### Brief Description of Drawings

Embodiments will now be described, by way of example only, with reference to the accompanying schematic drawings in which corresponding reference symbols indicate corresponding parts. In the drawings, like numerals designate like elements. Multiple instances of an element may each include separate letters appended to the reference number. For example, two instances of a particular element "20" may be labelled as "20a" and "20b". The reference number may be used without an appended letter (e.g. "20") to generally refer to an unspecified instance or to all instances of that element, while the reference number will include an appended letter (e.g. "20a") to refer to a specific instance of the element.
Figure 1 schematically shows a target processing system including a signal conductor path according to an embodiment;
Figure 2 shows a perspective view of an embodiment of an optical fiber path arrangement, including five fiber feedthrough devices;
Figures 3a-3b show perspective views of an optical fiber feedthrough device according to an embodiment;
Figures 4a-4b schematically show perspective views of a slotted member from figures 3a-3b;
Figures 5a-5c schematically show perspective views of a PCB feedthrough device according to embodiments; and
Figure 6 schematically shows a signal conductor group in the form of a printed circuit board.

The figures are meant for illustrative purposes only, and do not serve as restriction of the scope or the protection as laid down by the claims. It can further be mentioned that the figures are not necessarily drawn to scale.

### Description of Embodiments

The following is a description of certain embodiments of the invention, given by way of example only and with reference to the figures. In the figures, Cartesian coordinates will be used to describe spatial relations for exemplary embodiments of the feedthrough device, signal conductor path arrangement, vacuum chamber, and processing system. Reference symbols X, Y, and Z are used to indicate first, second, and third orthogonal directions, respectively, and may include distinct subscripts to indicate directional definitions for different objects. A plus or minus sign is used to specifically indicate a positive or negative direction, or omitted if the sign is clear from the context or immaterial.

It should be understood that the directional definitions and preferred orientations presented herein merely serve to elucidate geometrical relations for specific embodiments. The concepts discussed herein are not limited to these directional definitions and preferred orientations. Similarly, directional terms such as "top," "bottom," "left," "right," "up," "down," "upper," "lower," "proximal," "distal" and the like, are used herein solely to indicate relative directions and are not otherwise intended to limit the scope of the invention or claims.

The term "surface" is used herein to generally refer to a two-dimensional parametric surface region, which may have either an entirely flat shape (i.e. a plane), a piece-wise flat shape (e.g. a polygonal surface), a curved shape (e.g. cylindrical, spherical, parabolic surface, etc.), a recessed shape (e.g. stepped or undulated surface), or a more complex shape. The term "plane" is used herein to refer to a flat surface defined by three non-coinciding points.

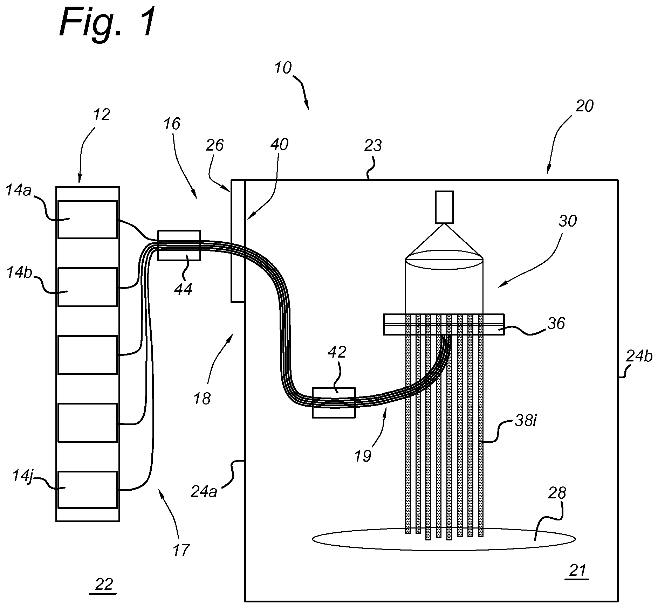

Figure 1 schematically shows a target processing system 10 with a vacuum chamber 20 and a signal conductor path arrangement 40. Signal conductor cabling 16 is hermetically passed through a chamber wall 23, 24 that separates two regions 21, 22 with different ambient conditions. In this exemplary embodiment, the target processing system 10 is a charged particle lithography system, which is adapted for lithographic processing of a semiconductor target 28 e.g. to create structures onto a resist-covered semiconductor substrate. Here, the different ambient conditions involve pressure differences.

As described above, the signal conductor cabling may comprise optical fibers and/or electrical cabling or wiring, for example in the form of one or more PCB's.

The target processing system 10 comprises a vacuum chamber 20, and a particle beam projection column 30. The vacuum chamber 20 is configured to maintain a vacuum environment in the inner region 21. This vacuum environment corresponds with a chamber pressure Pᵢ of 10⁻³ millibar or lower, for example a pressure range of 10⁻⁷ millibar to 10⁻⁴ millibar. The target processing system 10 comprises or is coupled to evacuation means, for example a vacuum pump system (not shown), which is configured to evacuate (i.e. withdraw air and/or gas from) the vacuum chamber 20.

The target processing system 10 also comprises a control unit 12. This controller 12 may be located outside the vacuum chamber 20, for example in a separate cabinet that is positioned on top of the vacuum chamber 20 (not shown).

The projection column 30 is accommodated inside the vacuum chamber 20, and is adapted to generate, shape, and project one or more charged particle beams, for example electron beamlets 38, toward the target 28. The target 28 is also located inside the vacuum chamber 20 during lithographic processing. The projection column 30 may comprise various (electron) optical elements, among which are means for forming the plurality of beamlets 38, and a beam switching module 36. The beam switching module 36 is controllable by optical signals, to modulate and select beamlets 38 for projection onto a surface of the target 28. The optical signals may be transmitted into the vacuum chamber via the optical fiber feedthrough device as described herein.

Various components located within the vacuum chamber, including the electron optical components, are connected to respective power supplies, located outside the vacuum chamber, via electrical conductors or cabling. Further electrical conductors or cabling provide control signals from a control unit, located outside the vacuum chamber, to various electrical components and devices located within the vacuum chamber. Still further signal conductors, including electrical conductors and/or optical fibers, may be provided for transmitting signals to and/or from various sensors located within the vacuum chamber to the control unit. All these types of signals may be transmitted into the vacuum chamber via the electrical feedthrough devices, in particular the PCB feedthrough device, as described herein. For example, electronic components provided in the beam switching module 36 may be powered and/or controlled by signal transmitted via the PCB feedthrough device.

The vacuum chamber 20 is formed by multiple walls 23, 24, which are mechanically interconnected and form an impermeable material barrier between the chamber's inner region 21 and the region 22 outside the vacuum chamber 20. On one lateral wall 24a, the vacuum chamber 20 includes a feedthrough section 26, which comprises the signal conductor path arrangement 40. In this exemplary embodiment, the feedthrough section 26 of the signal conductor path arrangement 40 includes a relatively flat panel structure, with two opposite panel surfaces that face laterally into and outwards from the vacuum chamber 20, respectively. The signal conductor path arrangement 40 is provided with a plurality of feedthrough devices 50, which are adapted for routing groups of signal conductors, e.g. groups 60 of optical fibers 61 or a PCB 160 comprising electrical conductors 161, through the feedthrough section 26 of lateral wall 24a. The feedthrough devices, which will be described in more detail herein below, enable transmitting the various signals through the vacuum boundary of the vacuum chamber while maintaining vacuum conditions.

These signal conductors are part of the signal conductor cabling 16, which traverses the outer region 22, and passes in a hermetically sealed manner through the feedthrough section 26 of the lateral wall 24a, to the inner region 21. The cabling 16 generally includes a sequence of interconnected cable segments 17, 18, 19. A first cabling segment 17 is located in the outer region 22, and is subjected to external ambient conditions (which in this example corresponds to a normal atmospheric pressure P₀). The second cabling segment 18 extends through the wall section 26, and is partly located in the outer region 20, and partly located in the inner region 21, the latter region being associated with processing conditions (which in this case corresponds to the low pressure Pᵢ). The third cabling segment 19 is located entirely in the inner region 21, and extends through the vacuum chamber 20 towards the beam switcher module 36. Signal conductor groups in the second cabling segment 18 comprise an ordered group of first connectors 42 at a first end that is located in the inner region 21, and an ordered group of second connectors 44 at an opposite second end that is located in the outer region 22. The first and second connectors 42, 44 may for example be multipole connectors.

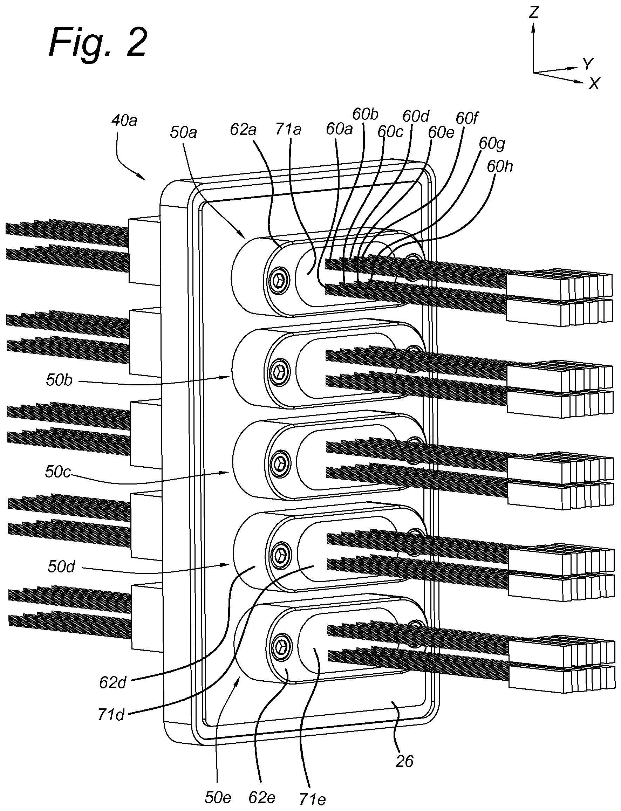

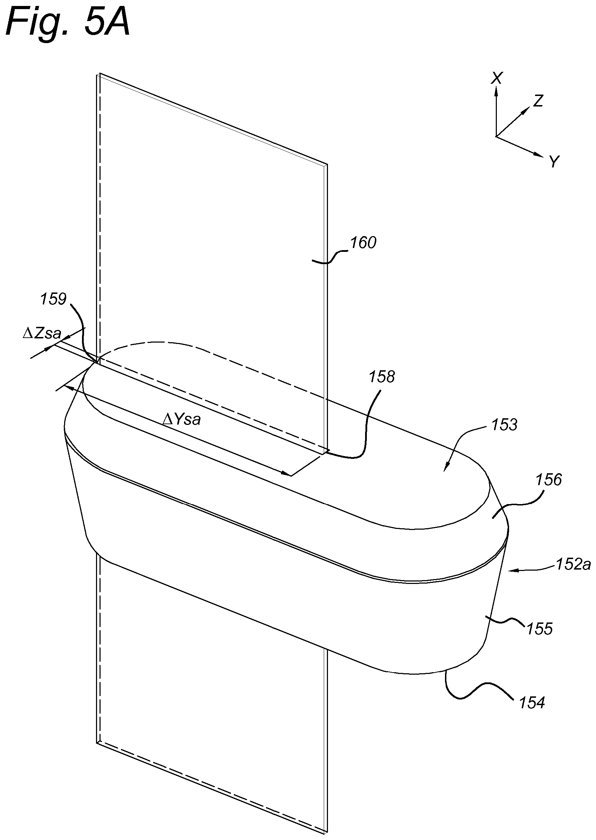

Figure 2 schematically shows an exemplary embodiment of a signal conductor path arrangement 40 in the target processing system 10 from figure 1. In this example, the signal conductor path arrangement 40 is formed as a fiber path arrangement 40a. However, the concept of the fiber path arrangement of figure 2 can analogously be applied for other types of signal conductor path arrangements, for example an electrical conductor path arrangement comprising PCB feedthrough devices 150 as described with reference to figures 5a to 5c herein below.

In the embodiment of figure 2, the optical fiber path arrangement 40a includes five fiber feedthrough devices 50a - 50e. In other embodiments, the fiber path arrangement may include any positive integer number of feedthrough devices. In this example, the optical fiber path arrangement 40a comprises a flat panel 26 with five regions onto which the five fiber feedthrough devices 50 are mounted in a hermetically sealed manner. The panel 26 itself is formed as a unit that is sealingly attachable to and removable from the lateral wall 24a of the vacuum chamber 20, to facilitate manufacturing and/or maintenance of the optical fiber path arrangement 40a.

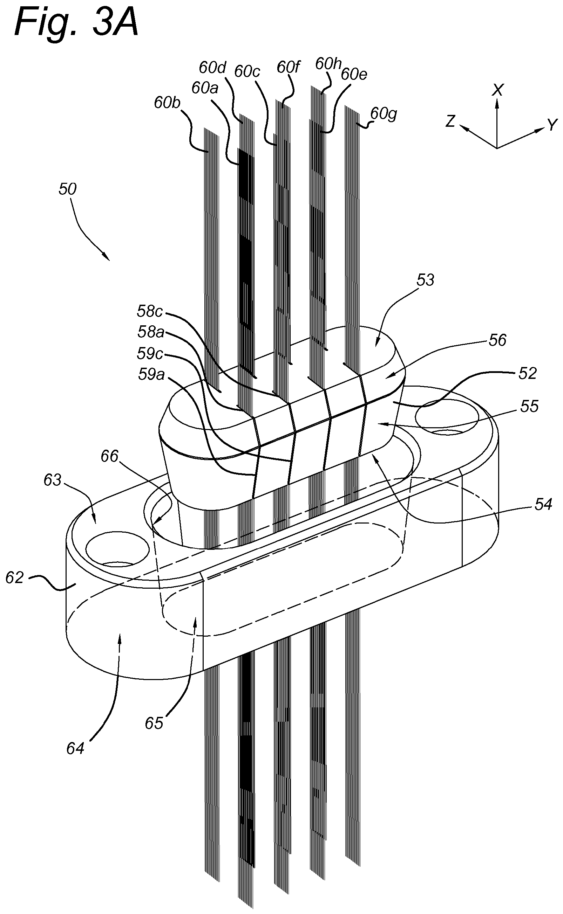

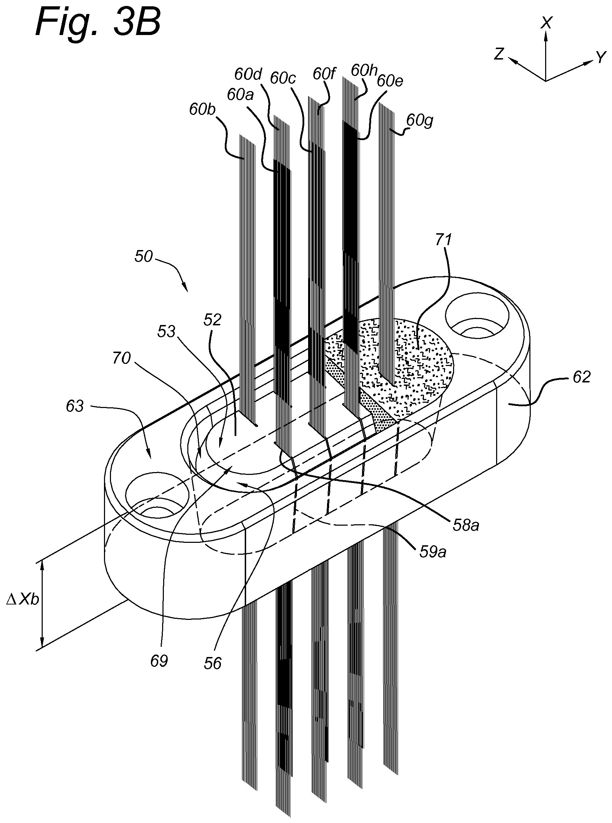

Figures 3a and 3b show details of a single fiber feedthrough device 50 from the arrangement 40a of figure 2. The fiber feedthrough device 50 comprises a slotted member 52, a base 62, a plurality of fiber groups 60, and a body of sealing material 71. Figure 3a shows the feedthrough device 50 in largely disassembled state, wherein the slotted member 52 is not inserted into the base 62. Figure 3b shows the feedthrough device 50 in an assembled state, wherein the slotted member 52 is accommodated in the base 62, and the sealing body 71 is applied (only partly shown for illustration purposes). Features described above with reference to figure 1 are also present in the arrangement shown in figures 2 and 3a-3b.

In figure 2, the optical fiber path arrangement 40a is shown from a position corresponding to the outer region 22 i.e. outside the vacuum chamber 20. Each of these feedthrough devices 50 includes a slotted member 52 (see figure 3a), which is accommodated in a through hole 65 of an associated base 62, and covered by a corresponding sealing body 71. Each such slotted member 52 forms a passageway for a plurality of flat fiber groups 60. The fiber groups 60 extend with longitudinal portions along a first direction X (also indicated as feedthrough direction) through associated slotted members 51 of corresponding feedthrough devices 50. Figures 2-3b only indicate fiber groups 60a-60h, which are associated with the uppermost feedthrough device 50a. The sealing bodies 71 cover portions of corresponding feedthrough devices 50 where the fiber groups 60 exit these devices 50, and locally envelop the fiber groups 60 to provide material barriers that hermetically separate the inner region 21 of the vacuum chamber 20 from the outer region 22. In this example, the inner region 21 is located at a side of the panel 26 that faces towards a negative feedthrough direction -X, and the outer region 22 is located at a side of the panel 26 that faces towards a positive feedthrough direction +X.

Although the embodiments of figures 3a-3b are discussed with reference to signal conductors in the form of optical fibers, the teaching analogously applies to signal conductors in the form of electrical conductors or wires. The slotted member, the base and the sealing body may be analogously used for a PCB feedthrough, where a PCB is inserted into the slots. Specific embodiments of such PCB feedthroughs are illustrated in figures 5a-5c and described further below.

Figure 3a illustrates that the slotted member 52 is formed by a body of solid material, which in this example consists essentially of aluminum. Along the positive and negative feedthrough directions ±X, the slotted member 52 is delimited by the first surface 53 and the second surface 54, respectively. The first and second surfaces 53, 54 are located on essentially opposite sides of the slotted member 52. Along second and third directions Y, Z, the slotted member 52 is delimited by a side surface 55, 56 that extends along the entire periphery of the slotted member 52. The side surface 55, 56 interconnects the first and second surfaces 53, 54.

Cross-sectional outer contours of this side surface 55, 56 in transverse YZ-planes resemble stadium shapes. A stadium is a two-dimensional geometric figure composed of a rectangle with semicircles at two opposite sides, with a periphery including two linear segments that interconnect two semi-circular segments. The stadium-shaped cross-sections of the side surface 55, 56 may include one or more small recesses and/or protrusions, though.

The side surface 55, 56 of the slotted member 52 has a first tapered surface segment 55 bordering on the second surface 54, and a second tapered segment 56 bordering on the first surface 53. The tapered shapes imply that the (stadium-shaped) cross-sectional outer contours of each of the surface segments 55, 56 in transverse YZ-planes are congruent, and increasing in size (first segment 55) or decreasing in size (second segment 56) as a function of position along the positive feedthrough direction +X.

The slotted member 52 defines a plurality of slots 58. Each slot 58 forms a substantially flat cut-out, which extends entirely through the solid body of the slotted member 52 along the feedthrough direction X. Each group 60 of fibers is accommodated within an associated slot 58.

The base 62 is formed by a distinct body, which is also formed of a solid material. In this example, the base 62 also consists essentially of aluminum. The base 62 defines a first outer surface 63 and a second outer surface 64 on essentially opposite sides, viewed along the feedthrough direction X. In this example, the first and second outer surfaces 63, 64 are flat and substantially parallel. A distance between the first and second surfaces 63, 64 corresponds to a thickness ΔXb of the base 62, which in this example is about 20 millimeters. In use, the base 62 is rigidly fixed to the panel 26 of figure 2 and sealed with respect to this panel e.g. by means of an O-ring (not shown) provided on the second outer surface 64.

The base 62 defines a central through hole 65, which extends entirely through the base 62. The through hole 65 opens into the first outer surface 63 at one end, and into the second outer surface 64 at the opposite end. Along the second and third directions Y, Z, the through hole 65 is delimited by an inner surface 66 of the base 62. This inner surface 66 also has a tapered stadium shape. This stadium-shaped inner surface 66 is predominantly congruent with the first side surface segment 55 of the slotted member 52. In this way, the slotted member 52 can be arranged inside the aperture 65 of the base 62 in a form-fitting manner.

Figure 3b shows the slotted member 52 arranged in a form-fitting manner inside the through hole 65. In this assembled state, the first side surface segment 55 of the slotted member 52 and the inner surface 66 of the base 62 abut, and the inner surface 66 covers the parts of the longitudinal openings 59 that are located at the first side surface segment 55.

In the assembled state of the embodiment shown in figure 3b, the first surface 53 of the slotted member 52 is receded with respect to the first surface 63 of the base 62. The first surface 53 of the slotted member 52 and part of the inner surface 66 of the base 62 jointly define a receptacle 69. In this example, the receptacle 69 is predominantly stadium-shaped.

In order to form the sealing body 71, the receptacle 69 is initially filled with a sealant material. In this example, the receptacle 69 is filled up to the level of the first surface 63. After curing, this sealant material forms the sealing body 71. This sealing body 71 covers the first surface 53 and the second surface segment 56 of the slotted member 52, as well as the parts of the slots 58 where the fiber groups 60 exit the slots 58, to envelop the fiber groups 60. In figure 3b, only part of the sealing body 71 is shown for illustrative purposes. It should be understood that, in this example, the completed sealing body 71 occupies the entire space of the receptacle 69, to cover all slots 58 and envelop all fiber groups 60 in a sealing manner.

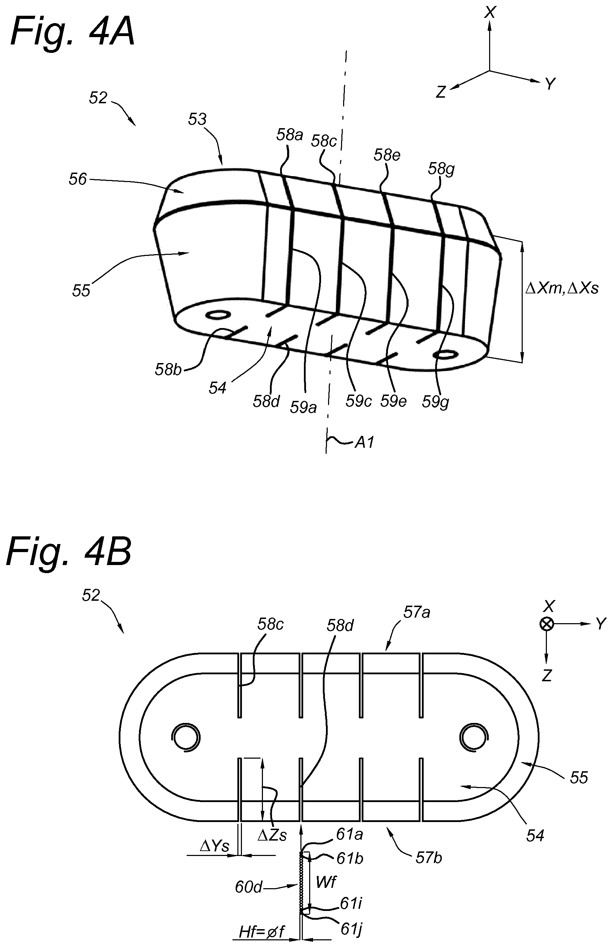

Figures 4a-4b schematically show more details of the slotted member 52 from figures 3a-3b. Similar or analogous details apply for the slotted member 152 from figure 5a-5c below. Each slot 58 in the slotted member 52 extends entirely through the solid body of the slotted member 52 along the feedthrough direction X, between the first surface 53 and the second surface 54. A distance between the first surface 53 and second surface 54 of the slotted member 52 corresponds with a thickness ΔXm of the slotted member 52. In this example, the slotted member thickness ΔXm about 17 millimeters. The length ΔXs of the slot 58 in the feedthrough direction X is identical to the thickness ΔXm of the slotted member 52. The thickness ΔXb of the base 62 along the feedthrough direction X is sufficient to allow the parts of the longitudinal openings 59 that are located at the first side surface segment 55 to be covered by the inner surface 66.

Figure 4a illustrates that the slots 58 also open into longitudinal openings 59, which extend along the entire side surface 55, 56 of the slotted member 52, thus intersecting both the first tapered side surface segment 55 and the second tapered side surface segment 56. These longitudinal openings 59 are provided on both linear portions 57a, 57b (see figure 4b) of the side surface 55, 56 of the slotted member 52.

Figure 4b illustrates interrelations between the slots 58 and the fiber groups 60 in more detail. The individual fibers 61 in one fiber group 60 are laterally arranged in a linear array. In this example, each fiber group 60 is formed by at least twenty fibers 61, which extend alongside each other in a single-layered array of co-directional and abutting fibers 61. The fibers 61 locally extend in a mutually parallel manner, so that the local tangent vectors of the fibers 61 point in the same direction (here along the feedthrough direction X). Each individual fiber 61 has only two directly neighboring fibers 61. The exception to this are the first fiber 61a and the last fiber 61j, which are arranged at the two sides of the fiber group 60, and which have only one directly neighboring fiber (i.e. the second fiber 61b and the penultimate fiber 61i respectively). The optical fibers 61 have essentially identical fiber diameters Øf. The fiber diameter Øf may be in a range of about 0.125 millimeters to 0.25 millimeters. In this example, the fiber diameter Øf has a value of about 0.175 millimeters. As a result, a thickness Hf of the fiber group 60 along the second direction Y is substantially equal to the fiber diameter Øf, and a width Wf of the fiber group 60 along the third direction Z is at least twenty times the fiber diameter Øf.

Each slot 58 extends perpendicularly into the slotted member 52, here along the (positive/negative) third direction Z (also indicated as the depth direction Z). The slot 58 has a depth ΔZs in this depth direction Z, which is at least equal to the group width Wf (i.e. at least twenty times the fiber diameter Øf in this example). The slot 58 has a width ΔYs in the second direction Y, which complies with Øf < ΔYs < 2·Øf. In this example, the slot width ΔYs is only marginally larger than the fiber diameter Øf, and has a value of about 0.25 millimeters. When accommodated inside the corresponding slot 58, the fibers 61 will not cross each other, at least along the entire extent of the slot 58.

The optical fibers 61 are coated on outer surfaces with aluminum, to reduce outgassing effects inside the vacuum chamber 20. This aluminum coating also facilitates adhesion of the sealing body 71 to the slotted member 52, the base 62, and the optical fibers 61.

In alternative embodiments, some or all of the fibers in one fiber group do not directly abut in a lateral direction (here, in the depth direction Z). Instead, some or all pairs of directly neighboring fibers may extend alongside each other while defining a small space in between. Such spaces allow a larger portion of the transverse cross-sectional peripheries of corresponding fibers to be enveloped by the sealing body (e.g. cured sealant material). In such embodiments, a width Wf of the fiber group will exceed the product of the number of fibers in the group and the fiber diameter Øf.

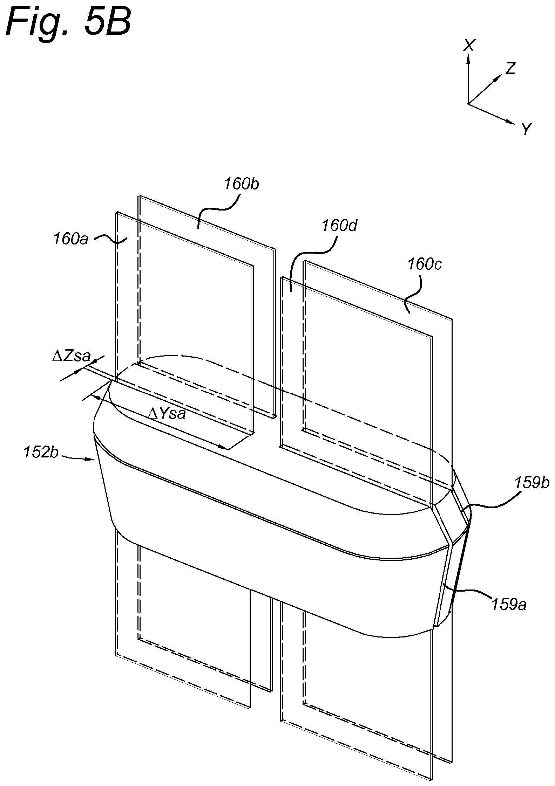

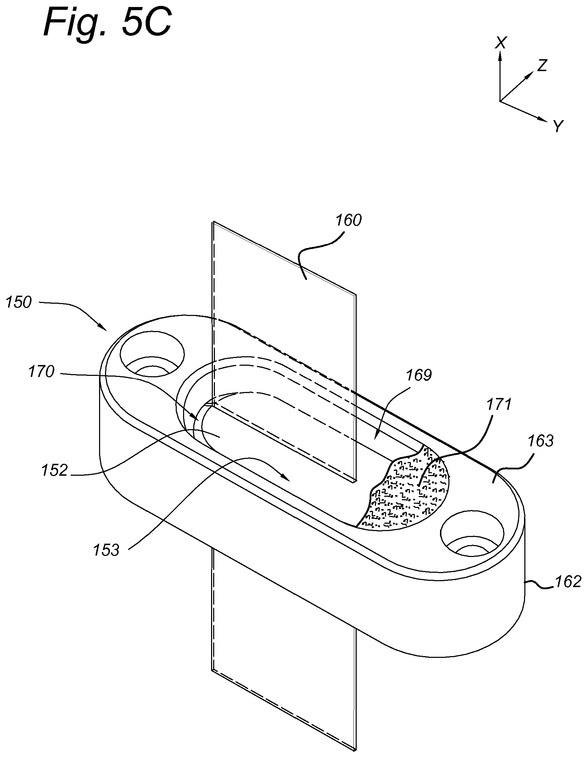

Figures 5a and 5b show details of PCB feedthrough devices, such as the PCB feedthrough device 150 illustrated in figure 5c in an assembled state. Figures 5a and 5b show a slotted member 152a, 152b, provided with slots 159, 159a, 159b into each of which a PCB 160, 160a-160d is inserted. In figure 5a and 5b the slotted member 152a, 152b is not inserted into the base 162.

The slotted members 152, 152a, 152b, referred to herein below by 152, of figures 5a-5c are analogous to the slotted member 52 of figures 3a and 3b. The slotted members 152 are formed by a body of solid material, and for example consist essentially of aluminum. Along the positive and negative feedthrough directions ±X, the slotted member 152 is delimited by the first surface 153 and the second surface 154, respectively. The first and second surfaces 153, 154 are located on essentially opposite sides of the slotted member 152. Along second and third directions Y, Z, the slotted member 152 is delimited by a side surface 155, 156 that extends along the entire periphery of the slotted member. The side surface 155, 156 interconnects the first and second surfaces 153, 154.

Cross-sectional outer contours of this side surface 155, 156 in transverse YZ-planes resemble stadium shapes. A stadium is a two-dimensional geometric figure composed of a rectangle with semicircles at two opposite sides, with a periphery including two linear segments that interconnect two semi-circular segments. The stadium-shaped cross-sections of the side surface 155, 156 may include one or more small recesses and/or protrusions, though.

The side surface 155, 156 of the slotted member 152 has a first tapered surface segment 155 bordering on the second surface 154, and a second tapered segment 156 bordering on the first surface 153. The tapered shapes imply that the (stadium-shaped) cross-sectional outer contours of each of the surface segments 155, 156 in transverse YZ-planes are congruent, and increasing in size (first segment 155) or decreasing in size (second segment 156) as a function of position along the positive feedthrough direction +X.

The slotted member 152 defines one or more slots 158. The slotted member 152a of figure 5a is provided with one slot 158, and hence feeds through one PCB 160. The slotted member 159b of figure 5b comprises four slots 158, enabling feeding through four PCB's 160-160d. The number of slots 158 provided in the slotted member, as well as their arrangement, i.e. position and orientation in the slotted member, and the specific dimensions of the slotted member 152, may be selected based on the specific application, and the arrangements of PCB's and/or electrical connections which are to be arranged in the feedthrough.

In the illustrated embodiment, the slots 158 in the slotted member 152 for the PCB feedthrough device are directed along the Y direction, i.e. substantially perpendicular to the direction of the slots 58 in the slotted member 52 of the optical fiber feedthrough device 50. However, it should be noted that the slots 158 for the PCB feedthrough device may alternatively be oriented along the Z direction, in the same direction as the slots 58 for the optical fiber feedthrough device, and vice versa. Furthermore, the slotted member may be configured with one or more slots 158 for accommodating a PCB, and one or more slots 58 for accommodating optical fiber groups.

Each slot 158 forms a substantially flat cut-out, which extends entirely through the solid body of the slotted member 152 along the feedthrough direction X. Each PCB 160 is accommodated within an associated slot 158. The width ΔZsa of the slot 158 slightly exceeds the thickness of the PCB 160 in the area thereof passing through the slot 158. For example, the PCB may be 300 µm thick, whereby the slot has a width of 400-500 µm. The depth ΔYsa of the slot preferably exceeds the width of the PCB 160 in the area thereof passing through the slot 158.

Analogous to the illustration in figure 4a, each slot 158 in the slotted member 152 extends entirely through the solid body of the slotted member 152 along the feedthrough direction X, between the first surface 153 and the second surface 154. A distance between the first surface 153 and second surface 154 of the slotted member 152 corresponds with a thickness ΔXm of the slotted member 152. The length ΔXs of the slot 158 in the feedthrough direction X is identical to the thickness ΔXm of the slotted member 152. The thickness ΔXb of the base 162 along the feedthrough direction X is sufficient to allow the parts of the longitudinal openings 159 that are located at the first side surface segment 155 to be covered by the inner surface.

The slots 158 also open into longitudinal openings 159, which extend along the entire side surface 155, 156 of the slotted member 152, thus intersecting both the first tapered side surface segment 155 and the second tapered side surface segment 156.

Figure 5c shows a PCB feedthrough device 150, which may be comprised in the signal conductor path arrangement 40 of figure 1. The PCB feedthrough device 150 comprises a slotted member 152, a base 162, a PCB 160 comprising a plurality of electrical conductors (not illustrated in figure 5a-5c), and a body of sealing material 171. Figure 5c shows the feedthrough device 150 in an assembled state, wherein the slotted member 152 is accommodated in the base 162, and the sealing body 171 is applied (only partly shown for illustration purposes). Features described above with reference to figure 1 are also present in the arrangement shown in figures 5a-5c. The slotted member 152 has been described with reference to figure 5a, 5b.

In particular, the feedthrough device of figure 5c comprises a slotted member and PCB as illustrated in figure 5a. Analogously, the slotted member 152b and PCB's 160a-c of figure 5c can be arranged in the base 162 to form a PCB feedthrough device.

The base 162, illustrated in figure 5c, is similar to the base 62 of figures 3a, 3b. The base 162 is formed by a distinct body, which is also formed of a solid material, for example, essentially aluminum. The base 162 defines a first outer surface 163 and a second outer surface (similar to the second outer surface 64) on essentially opposite sides, viewed along the feedthrough direction X. In this example, the first and second outer surfaces are flat and substantially parallel. A distance between the first and second surfaces corresponds to a thickness ΔXb of the base 162, which in this example is about 20 millimeters. In use in a signal conductor path arrangement according to the principle illustrated in figure 2, the base 162 is rigidly fixed to the panel 26 and sealed with respect to this panel e.g. by means of an O-ring (not shown) provided on the second outer surface.

The base 162 defines a central through hole (similar to the through hole 65), which extends entirely through the base 162. The through hole opens into the first outer surface 163 at one end, and into the second outer surface at the opposite end. Along the second and third directions Y, Z, the through hole is delimited by an inner surface (similar to the inner surface 66) of the base 162. This inner surface also has a tapered stadium shape. This stadium-shaped inner surface is predominantly congruent with the first side surface segment 155 of the slotted member 152. In this way, the slotted member 152 can be arranged inside the through hole of the base 162 in a form-fitting manner.

Figure 5c shows the slotted member 152 arranged in a form-fitting manner inside the through hole 65. In this assembled state, the first side surface segment 155 of the slotted member 152 and the inner surface of the base 162 abut, and the inner surface covers the parts of the longitudinal openings 159 that are located at the first side surface segment 155.

In the embodiment of figure 5c the first surface 153 of the slotted member 152 is receded with respect to the first surface 163 of the base 162, whereby the first surface 153 and part of the inner surface jointly define a receptacle 169.

In order to form the sealing body 171, the receptacle 169 is initially filled with a sealant material. In this example, the receptacle 169 is filled up to the level of the first surface 163. After curing, this sealant material forms the sealing body 171. This sealing body 171 covers the first surface 153 and the second surface segment 156 of the slotted member 152, as well as the parts of the slots 158 where the PCB's 160 exit the slots 158, to envelop the PCB 160. In figure 5c, only part of the sealing body 171 is shown for illustrative purposes. It should be understood that, in this example, the completed sealing body 171 occupies the entire space of the receptacle 169, to cover all slots 158 and envelop all PCB's 160 in a sealing manner.

The PCB feedthrough devices as described herein, for example the PCB feedthrough 150, may be incorporated in a signal conductor path arrangement, for example forming a PCB path arrangement, analogous to the optical fiber path arrangement 40a of figure 2.

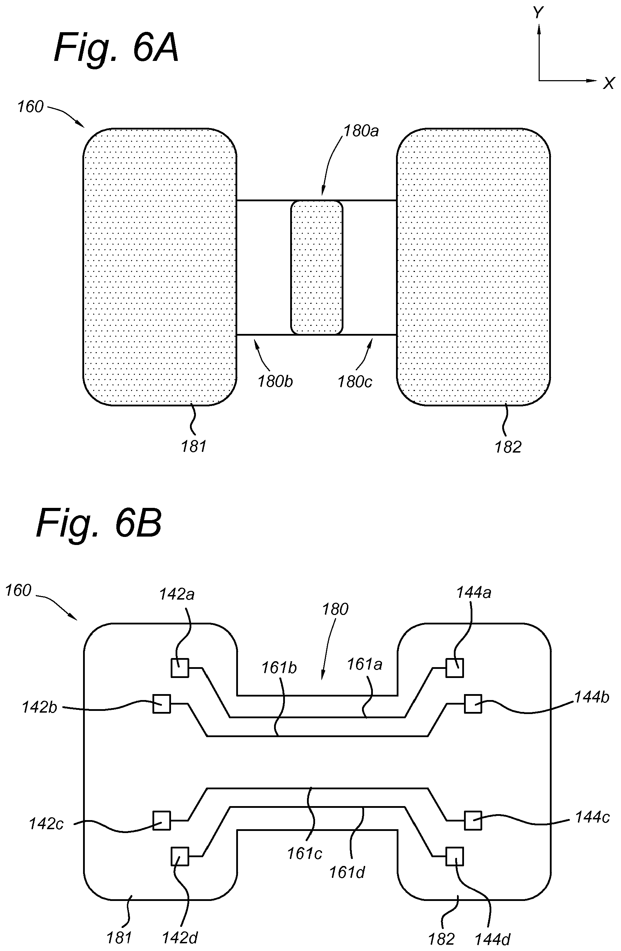

Figure 6a and 6b schematically illustrate an embodiment of a PCB 160 of the PCB feedthrough device 150. The PCB 160 comprises a central portion 180, whose middle portion 180a is configured to be inserted into the slot 158 and to be sealed by the sealing body 171. To this end, the outer surfaces of the middle portion 180a are provided with a material providing good adhesion with the sealing body, such as to form a hermetic seal. This can for example be realized by a copper coating, or any other material to which the sealing body adhere. The PCB 160 comprises a first part 181, arranged on the vacuum side of the feedthrough device, and a second part 182, arranged on the ambient side of the feedthrough device. The first and second parts 181, 182 are connected to the central part 180 via distal portions 180b, 180c thereof. The distal portions 180b, 180c are not in contact with the sealing body and hence do not necessarily be provided with a material having good adhesion therewith, although they may be provided with such material. The different parts of the PCB 160, in particular the first part 181 and the central part 180, are further configured to be vacuum compatible, having low outgassing properties.

The central part 180 of the PCB may be formed by a flexible PCB, or by a rigid PCB, depending e.g. on the desired arrangement, e.g. orientation, of the first and/or second parts 181, 182 in relation to the central part 180. The first and second parts 181, 182 are generally rigid.

As illustrated in figure 6b, the first and second parts 181, 182 comprise first connectors 142a-142d and second connectors 144a-144d, respectively. The first connectors 142 are configured for connection to cables or wiring located within the vacuum chamber, e.g. to the third cable segment 19 of figure 1. Analogously, the second connectors 144 are configured for connection to cables or wiring located outside the vacuum chamber, e.g. to the first cable segment 17 of figure 1. Furthermore, the first and second parts 181, 182 may comprise various electronic components (not illustrated). Electrical conductors 161a-161d, passing through the central part 180, connect the first and second conductors 142a-d, 144a-d. For ease of illustration, only four conductors are shown in figure 6b, although the number of conductors may in general be much larger. Furthermore, in figure 6b only one layer of conductors is shown. However, the PCB 160 may comprise a plurality of layers of conductors. Hence, the PCB provides an ordered arrangement of electrical conductors.

The present invention may be embodied in other specific forms without departing from its spirit or essential characteristics. The described embodiments are to be considered in all respects only as illustrative and not restrictive. The scope of the invention is, therefore, indicated by the appended claims rather than by the foregoing description. It will be apparent to the person skilled in the art that alternative and equivalent embodiments of the invention can be conceived and reduced to practice. All changes which come within the meaning and range of equivalency of the claims are to be embraced within their scope.

Those skilled in the art and informed by the teachings herein will realize that the invention is applicable for feeding through any number of signal conductor groups comprising multiple signal conductors, such as optical fibers and/or electrical conductors, for example arranged in a PCB. Any number of signal conductor path arrangements may be used, and each arrangement may include any number of feedthrough devices.

The proposed feedthrough device and/or signal conductor path arrangement may be employed in various types of vacuum chambers and/or target processing systems. The target processing system may for example be a charged particle beamlet lithography system, an electromagnetic beam lithography system, or another type of processing system that requires a hermetic feedthrough of signal conductors between regions with different ambient conditions.

Apart from the above, it will be appreciated that the cross-sectional shapes of the side surface of the slotted member and the inner surface of the base of a feedthrough device do need to be shaped according to a stadium. Instead, other shapes may be possible, for example rounded rectangular, elliptic, circular, polygonal, or other cross-sectional shapes.

### List of Reference Symbols

- 10: target processing system (e.g. lithography system)
- 12: system controller
- 14: optical signal generators
- 16: signal conductor cabling
- 17: first cable segment (external)
- 18: second cable segment (intermediate transition)
- 19: third cable segment (internal)
- 20: vacuum chamber
- 21: first region (e.g. vacuum chamber region)
- 22: second region (e.g. outer region)
- 23: upper chamber wall
- 24: lateral chamber wall
- 26: feedthrough wall section
- 28: target
- 30: particle beam column
- 32: particle beam source (e.g. electron beam source)
- 34: particle beam collimator
- 36: beamlet switcher module
- 37: blanker controller
- 38: beamlet
- 40: signal conductor path arrangement
- 42: first connector (e.g. internal connector)
- 44: second connector (e.g. external connector)
- 50: fiber feedthrough device
- 52: slotted member
- 53: first surface
- 54: second surface
- 55: first side surface segment
- 56: second side surface segment
- 57: flat surface portion
- 58: slot
- 59: longitudinal opening
- 60: flat fiber group
- 61: optical fiber
- 62: base
- 63: first surface
- 64: second surface
- 65: through hole (for slotted member)
- 66: inner surface
- 67: coupling aperture (e.g. lateral through hole)
- 68: mechanical coupling (e.g. bolt and nut)
- 69: receptacle
- 70: peripheral recess
- 71: sealing body
- 72: main seal portion
- 73: flange seal portion
- 142: first connectors (of PCB)
- 144: second connectors (of PCB)
- 150: PCB feedthrough device
- 152: slotted member (of PCB feedthrough device)
- 153: first surface (of PCB feedthrough device)
- 154: second surface (of PCB feedthrough device)
- 155: first side surface segment (of PCB feedthrough device)
- 156: second side surface segment (of PCB feedthrough device)
- 158: slot (of PCB feedthrough device)
- 159: longitudinal opening (of PCB feedthrough device)
- 160: printed circuit board (PCB)
- 161: electrical conductors in PCB
- 162: base (of PCB feedthrough device)
- 163: first outer surface
- 169: receptacle (of PCB feedthrough device)
- 170: peripheral recess (of PCB feedthrough device)
- 171: sealing body (of PCB feedthrough device)
- 180: central part (of PCB)
- 181: first part (of PCB)
- 182: second part (of PCB)
- A1: insertion axis
- X: first direction (feedthrough direction)
- Y: second direction (transversal direction)
- Z: third direction (e.g. depth direction)
- ΔXm: slotted member thickness
- ΔXb: base thickness
- ΔXs: slot length
- ΔYs: slot width
- ΔZs: slot depth
- ΔYsa: slot depth (PCB feedthrough embodiment)
- ΔZsa: slot width (PCB feedthrough embodiment)
- Wf: fiber group width
- Hf: fiber group thickness
- Øf: fiber diameter

## Claims

1. A signal conductor path arrangement (40), comprising:
a plurality of signal conductors (61; 161);
a sealing body (71; 171); and
a feedthrough device (50; 150) forming a hermetic seal around the plurality of signal conductors (61; 161), the signal conductors extending alongside each other to form a signal conductor group (60; 160) with a group width, wherein the feedthrough device comprises:
- a slotted member (52; 152), delimited by a first surface (53; 153) that faces predominantly towards a feedthrough direction (X), a second surface (54; 154) that faces predominantly opposite to the feedthrough direction, and a side surface (55, 56; 155, 156) that interconnects the first and second surfaces and faces outwards in a direction non-parallel to the feedthrough direction; and
- a base (62; 162) with a hole (65) that extends entirely through the base along the feedthrough direction, wherein the slotted member is accommodated in the hole, the hole opening into a first outer surface (63, 163) at one end of the hole and into a second outer surface (64, 164) at the opposite end of the hole;
wherein the slotted member further comprises at least one slot (59; 159), which extends along the feedthrough direction through the slotted member and opens into the first and second surfaces, to allow the signal conductor group to pass from the first surface through the slotted member to the second surface, a longitudinal portion of the signal conductor group being inside the slot to extend in the feedthrough direction (X) between the first and second surfaces, wherein the slot further opens into a longitudinal opening (59; 159) along the side surface, and extends from the side surface along a depth direction (Z; Y) transverse to the feedthrough direction up to a slot depth (ΔZs; ΔYsa) into the slotted member, wherein the slot depth is equal to or larger than the group width,
wherein the base (62; 162) defines an inner surface (66) that directly surrounds the hole (65) that opens into the first outer surface, wherein the inner surface (66) covers at least part of the side surface (55, 56; 155, 156) and the longitudinal opening (59; 159) of the slotted member (52; 152), when accommodated in the hole,
wherein the first surface (53; 153) of the slotted member (52; 152) is recessed along the feedthrough direction (X) relative to the first outer surface (63; 163) of the base directly around the hole (65) that opens into the first outer surface so that at least the first surface of the slotted member and the inner surface (66) of the base form a receptacle (69) accommodating the sealing body (71; 171), the receptacle configured initially to be filled with a sealant material to form the sealing body, and
wherein the sealing body (71; 171) covers the first surface (53; 153) of the slotted member and at least the part of the slot (58; 158) where the signal conductor group exits the slot, to envelop the signal conductor group and provide a hermetic barrier between first and second regions (21, 22) that are outside the slotted member and border on the first and second surfaces of the slotted member respectively.

2. The signal conductor path arrangement (40) according to claim 1, wherein the side surface (55, 56; 155, 156) of the slotted member has a cross-sectional shape that resembles a stadium or a rounded rectangle, and wherein the inner surface (66) of the base around the though hole has cross-sectional shape adapted to accommodate the slotted member in a form-fitting manner.

3. The signal conductor path arrangement (40) according to claim 1 or 2, wherein the side surface (55, 156; 155, 156) of the slotted member defines a flat surface portion (57) that extends in a translationally symmetric manner along a direction (Y) perpendicular to the feedthrough direction (X), wherein the longitudinal opening (59; 159) is located at the flat surface portion, and wherein the at least one slot (58; 158) extends along the depth direction and perpendicular to the flat surface portion into the slotted member.

4. The signal conductor path arrangement (40) according to any one of the preceding claims, wherein the side surface (55, 56; 155, 156) of the slotted member defines a first side surface segment (55; 155) that is inwardly tapered towards an axis (A1) along the feedthrough direction, and wherein the inner surface of the base (62; 162) is inwardly tapered congruent to the first side surface segment.

5. The signal conductor path arrangement (40) according to claim 4, wherein the side surface (55, 56; 155, 156) of the slotted member includes a second outer surface segment (56; 156) that is inwardly tapered, filleted, or chamfered towards the axis (A1) along the feedthrough direction (X) but oppositely with respect to the first side surface segment (55; 155), and/or wherein the inner surface of the base (62; 162) includes an inner surface segment that is outwardly tapered, filleted, or chamfered away from the axis, such that the second side surface segment and/or inner surface segment define an inwards peripheral recess (70; 170) directly bordering on the at least one longitudinal opening in the slotted member, the recess configured to accommodate a portion of the sealing body (71; 171).

6. The signal conductor path arrangement (40) according to any one of the preceding claims, wherein the plurality of signal conductors (61; 161) is provided as a plurality of optical fibers (61), a plurality of electrical conductors, and/or as conductors (161) in a printed circuit board (160).

7. The signal conductor path arrangement (40) according to any one of the preceding claims, comprising further signal conductors (61; 161), which extend alongside each other in arrays to form further signal conductor groups (60; 60i; 160) with group widths (Wfi);
wherein the slotted member includes further slots (58i; 158i), which extend along the feedthrough direction through the slotted member and open into the first and second surfaces to allow the signal conductor groups to pass from the first surface through the slotted member to the second surface;
wherein each further slot opens into a respective longitudinal opening (59i; 159i) along the side surface, and extends from the side surface up to a slot depth (ΔZsi; ΔYsa) into the slotted member, and
wherein the longitudinal openings are provided on the same and/or on opposite flat surface portions (57; 157) of the side surface of the slotted member, and the sealing body (71; 171) covers all slots to form the hermetic barrier.

8. The signal conductor path arrangement (40) according to any one of the preceding claims, wherein the signal conductors have a signal conductor diameter Øf and are arranged alongside each other into a single-layered array, to form the signal conductor group with a group thickness (Hf) that is at least equal to the signal conductor diameter but smaller than twice the signal conductor diameter.

9. The signal conductor path arrangement (40) of claim 8, wherein the slot (58; 158) has a slot width ΔYs; ΔZsa transverse to both the feedthrough direction (X) and the slot depth (ΔZs; ΔYsa), wherein the slot width is within a range defined by Øf < ΔYs; ΔZsa < 2·Øf.

10. The signal conductor path arrangement (40) according to any one of the preceding claims, wherein the slotted member (52; 152) and the base (62; 162) form rigid bodies comprising one or more solid materials, wherein the sealing body (71; 171) is formed from liquid sealant material that adheres to the one or more solid materials and fixes the slotted member to the base when cured.

11. The signal conductor path arrangement (40) according to claim 10, wherein the signal conductors are coated with a material that is essentially the same as the material of the slotted member (52; 152) or with a material different from the material of the slotted member but to which the liquid sealant material also adheres.

12. The signal conductor path arrangement (40) according to any one of the preceding claims, wherein the signal conductor group and/or further signal conductor groups comprise a first connector (42; 142) at a first end that is located in the first region (21), and/or comprise a second connector (44; 144) at an opposite second end that is located in the second region (22).

13. A target processing system (10), wherein the target processing system comprises a vacuum chamber (20) comprising at least one wall (23, 24) and the signal conductor path arrangement (40) according to any one of the preceding claims provided at or in the wall, wherein the group of signal conductors (60; 160) extends from a first region (21) on one side of the side wall, via the feedthrough device (50; 150) through the wall, to a second region (22) on an opposite side of the wall.

## Patentansprüche

1. Eine Signalleiterweganordnung (40), die Folgendes beinhaltet:
eine Vielzahl von Signalleitern (61; 161);
einen Dichtkörper (71; 171); und
eine Durchführungsvorrichtung (50; 150), die eine hermetische Dichtung um die Vielzahl von Signalleitern (61; 161) bildet, wobei sich die Signalleiter nebeneinander erstrecken, um eine Signalleitergruppe (60; 160) mit einer Gruppenbreite zu bilden, wobei die Durchführungsvorrichtung Folgendes beinhaltet:
- ein ausgespartes Element (52; 152), das begrenzt wird durch eine erste Oberfläche (53; 153), die hauptsächlich in eine Durchführungsrichtung (X) weist, eine zweite Oberfläche (54; 154), die hauptsächlich der Durchführungsrichtung entgegen weist, und eine Seitenoberfläche (55, 56; 155, 156), die die erste und die zweite Oberfläche verbindet und in einer zu der Durchführungsrichtung nichtparallelen Richtung auswärts weist; und
- eine Basis (62; 162) mit einem Loch (65), das sich entlang der Durchführungsrichtung vollständig durch die Basis erstreckt, wobei das ausgesparte Element in dem Loch aufgenommen wird, sich das Loch an einem Ende des Lochs in eine erste äußere Oberfläche (63, 163) und an dem entgegengesetzten Ende des Lochs in eine zweite äußere Oberfläche (64, 164) öffnet;
wobei das ausgesparte Element ferner mindestens eine Aussparung (59; 159) beinhaltet, die sich entlang der Durchführungsrichtung durch das ausgesparte Element erstreckt und sich in die erste und die zweite Oberfläche öffnet, um zu ermöglichen, dass die Signalleitergruppe von der ersten Oberfläche durch das ausgesparte Element zu der zweiten Oberfläche durchgeht, wobei sich ein Längsabschnitt der Signalleitergruppe innerhalb der Aussparung befindet, um sich in der Durchführungsrichtung (X) zwischen der ersten und der zweiten Oberfläche zu erstrecken,
wobei sich die Aussparung ferner in eine Längsöffnung (59; 159) entlang der Seitenoberfläche öffnet und sich von der Seitenoberfläche entlang einer zu der Durchführungsrichtung quer verlaufenden Tiefenrichtung (Z; Y) bis zu einer Aussparungstiefe (ΔZs; ΔYsa) in das ausgesparte Element erstreckt, wobei die Aussparungstiefe gleich der oder größer als die Gruppenbreite ist,
wobei die Basis (62; 162) eine innere Oberfläche (66) definiert, die das Loch (65), das sich in die erste äußere Oberfläche öffnet, direkt umgibt, wobei die innere Oberfläche (66) mindestens einen Teil der Seitenoberfläche (55, 56; 155, 156) und der Längsöffnung (59; 159) des ausgesparten Elements (52; 152) abdeckt, wenn dieses in dem Loch aufgenommen ist,
wobei die erste Oberfläche (53; 153) des ausgesparten Elements (52; 152) entlang der Durchführungsrichtung (X) relativ zu der ersten äußeren Oberfläche (63; 163) der Basis direkt um das Loch (65), das sich in die erste äußere Oberfläche öffnet, vertieft ist, sodass mindestens die erste Oberfläche des ausgesparten Elements und die innere Oberfläche (66) der Basis eine Aufnahme (69) bilden, die den Dichtkörper (71; 171) aufnimmt, wobei die Aufnahme konfiguriert ist, um anfangs mit einem Dichtungsmittel gefüllt zu werden, um den Dichtkörper zu bilden, und
wobei der Dichtkörper (71; 171) die erste Oberfläche (53; 153) des ausgesparten Elements und mindestens den Teil der Aussparung (58; 158), in dem die Signalleitergruppe aus der Aussparung austritt, abdeckt, um die Signalleitergruppe einzuhüllen und eine hermetische Barriere zwischen einer ersten und einer zweiten Region (21, 22), die außerhalb des ausgesparten Elements liegen und an die erste bzw. die zweite Oberfläche des ausgesparten Elements angrenzen, bereitzustellen.

2. Signalleiterweganordnung (40) gemäß Anspruch 1, wobei die Seitenoberfläche (55, 56; 155, 156) des ausgesparten Elements eine Querschnittsform aufweist, die einem Stadion oder einem gerundeten Rechteck ähnelt, und wobei die innere Oberfläche (66) der Basis um das Durchgangsloch eine Querschnittsform aufweist, die angepasst ist, um das ausgesparte Element auf eine formschlüssige Weise aufzunehmen.

3. Signalleiterweganordnung (40) gemäß Anspruch 1 oder 2, wobei die Seitenoberfläche (55, 56; 155, 156) des ausgesparten Elements einen flachen Oberflächenabschnitt (57) definiert, der sich auf eine translationssymmetrische Weise entlang einer zu der Durchführungsrichtung (X) senkrechten Richtung (Y) erstreckt, wobei sich die Längsöffnung (59; 159) an dem flachen Oberflächenabschnitt befindet und wobei sich die mindestens eine Aussparung (58; 158) entlang der Tiefenrichtung und senkrecht zu dem flachen Oberflächenabschnitt in das ausgesparte Element erstreckt.

4. Signalleiterweganordnung (40) gemäß einem der vorhergehenden Ansprüche, wobei die Seitenoberfläche (55, 56; 155, 156) des ausgesparten Elements ein erstes Segment (55; 155) der Seitenoberfläche definiert, das sich einwärts zu einer Achse (A1) entlang der Durchführungsrichtung verjüngt, und wobei sich die innere Oberfläche der Basis (62; 162) kongruent mit dem ersten Segment der Seitenoberfläche einwärts verjüngt.

5. Signalleiterweganordnung (40) gemäß Anspruch 4, wobei die Seitenoberfläche (55, 56; 155, 156) des ausgesparten Elements ein zweites Segment (56; 156) der äußeren Oberfläche umfasst, das entlang der Durchführungsrichtung (X), aber in Bezug auf das erste Segment (55; 155) der Seitenoberfläche entgegengesetzt einwärts zu der Achse (A1) verjüngt, abgerundet oder abgeschrägt ist, und/oder wobei die innere Oberfläche der Basis (62; 162) ein Segment der inneren Oberfläche umfasst, das von der Achse weg auswärts verjüngt, abgerundet oder abgeschrägt ist, sodass das zweite Segment der Seitenoberfläche und/oder das Segment der inneren Oberfläche eine periphere Einwärtsvertiefung (70; 170) definieren, die direkt an die mindestens eine Längsöffnung in dem ausgesparten Element angrenzt, wobei die Vertiefung konfiguriert ist, um einen Abschnitt des Dichtkörpers (71; 171) aufzunehmen.

6. Signalleiterweganordnung (40) gemäß einem der vorhergehenden Ansprüche, wobei die Vielzahl von Signalleitern (61; 161) als eine Vielzahl von Lichtleitfasern (61), eine Vielzahl von elektrischen Leitern und/oder als Leiter (161) in einer Leiterplatte (160) bereitgestellt ist.

7. Signalleiterweganordnung (40) gemäß einem der vorhergehenden Ansprüche, die weitere Signalleiter (61; 161) beinhaltet, die sich nebeneinander in Gruppierungen erstrecken, um weitere Signalleitergruppen (60; 60i; 160) mit Gruppenbreiten (Wfi) zu bilden;
wobei das ausgesparte Element ferner Aussparungen (58i; 158i) beinhaltet, die sich entlang der Durchführungsrichtung durch das ausgesparte Element erstrecken und sich in die erste und die zweite Oberfläche öffnen, um zu ermöglichen, dass die Signalleitergruppen von der ersten Oberfläche durch das ausgesparte Element zu der zweiten Oberfläche durchgehen;
wobei sich jede weitere Aussparung in eine jeweilige Längsöffnung (59i; 159i) entlang der Seitenoberfläche erstreckt und sich von der Seitenoberfläche bis zu einer Aussparungstiefe (ΔZsi; ΔYsa) in das ausgesparte Element erstreckt, und
wobei die Längsöffnungen an demselben und/oder an entgegengesetzten flachen Oberflächenabschnitten (57; 157) der Seitenoberfläche des ausgesparten Elements bereitgestellt sind und der Dichtkörper (71; 171) alle Aussparungen abdeckt, um die hermetische Barriere zu bilden.

8. Signalleiterweganordnung (40) gemäß einem der vorhergehenden Ansprüche, wobei die Signalleiter einen Signalleiterdurchmesser Øf aufweisen und nebeneinander zu einer Einzelschichtgruppierung angeordnet sind, um die Signalleitergruppe mit einer Gruppendicke (Hf) zu bilden, die mindestens gleich dem Signalleiterdurchmesser, aber kleiner als das Zweifache des Signalleiterdurchmessers ist.

9. Signalleiterweganordnung (40) gemäß Anspruch 8, wobei die Aussparung (58; 158) eine zu sowohl der Durchführungsrichtung (X) als auch der Aussparungstiefe (ΔZs; ΔYsa) quer verlaufende Aussparungsbreite ΔYs; ΔZsa aufweist, wobei die Aussparungsbreite innerhalb eines Bereichs liegt, der durch Øf < ΔYs; ΔZsa < 2 **·** Øf definiert ist.

10. Signalleiterweganordnung (40) gemäß einem der vorhergehenden Ansprüche, wobei das ausgesparte Element (52; 152) und die Basis (62; 162) starre Körper bilden, die ein oder mehrere feste Materialien beinhalten, wobei der Dichtkörper (71; 171) aus flüssigem Dichtungsmittel gebildet ist, das an dem einen oder den mehreren festen Materialien haftet und das ausgesparte Element an der Basis fixiert, wenn es gehärtet ist.

11. Signalleiterweganordnung (40) gemäß Anspruch 10, wobei die Signalleiter mit einem Material, das im Wesentlichen das gleiche ist wie das Material des ausgesparten Elements (52; 152), oder mit einem Material, das sich von dem Material des ausgesparten Elements unterscheidet, aber an dem das flüssige Dichtungsmittel ebenfalls haftet, beschichtet sind.

12. Signalleiterweganordnung (40) gemäß einem der vorhergehenden Ansprüche, wobei die Signalleitergruppe und/oder die weiteren Signalleitergruppen einen ersten Verbinder (42; 142) an einem ersten Ende, das sich in der ersten Region (21) befindet, beinhalten und/oder einen zweiten Verbinder (44; 144) an einem entgegengesetzten zweiten Ende, das sich in der zweiten Region (22) befindet, beinhalten.

13. Ein Zielverarbeitungssystem (10), wobei das Zielverarbeitungssystem eine Vakuumkammer (20), die mindestens eine Wand (23, 24) beinhaltet, und die Signalleiterweganordnung (40) gemäß einem der vorhergehenden Ansprüche, die an oder in der Wand bereitgestellt ist, beinhaltet, wobei sich die Gruppe von Signalleitern (60; 160) von einer ersten Region (21) auf einer Seite der Seitenwand über die Durchführungsvorrichtung (50; 150) durch die Wand zu einer zweiten Region (22) auf einer entgegengesetzten Seite der Wand erstreckt.

## Revendications

1. Un agencement pour piste conductrice de signal (40), comprenant :
une pluralité de conducteurs de signal (61 ; 161) ;
un corps d'étanchéification (71 ; 171) ; et
un dispositif de traversée (50 ; 150) formant un joint d'étanchéité hermétique autour de la pluralité de conducteurs de signal (61 ; 161), les conducteurs de signal s'étendant les uns à côté des autres afin de former un groupe de conducteurs de signal (60 ; 160) avec une largeur de groupe, le dispositif de traversée comprenant :
- un élément à fentes (52 ; 152), délimité par une première surface (53 ; 153) qui est prédominamment tournée vers une direction de traversée (X), une deuxième surface (54 ; 154) qui est prédominamment tournée à l'opposé de la direction de traversée, et une surface de côté (55, 56 ; 155, 156) qui raccorde entre elles les première et deuxième surfaces et est tournée vers l'extérieur dans une direction non parallèle à la direction de traversée ; et
- une base (62 ; 162) avec un trou (65) qui s'étend entièrement à travers la base le long de la direction de traversée, l'élément à fentes étant logé dans le trou, le trou ouvrant dans une première surface externe (63, 163) au niveau d'une extrémité du trou et dans une deuxième surface externe (64, 164) au niveau de l'extrémité opposée du trou ;
où l'élément à fentes comprend en outre au moins une fente (59 ; 159), laquelle s'étend le long de la direction de traversée à travers l'élément à fentes et ouvre dans les première et deuxième surfaces, afin de permettre au groupe de conducteurs de signal de passer de la première surface à la deuxième surface à travers l'élément à fentes, une portion longitudinale du groupe de conducteurs de signal se tenant à l'intérieur de la fente afin de s'étendre dans la direction de traversée (X) entre les première et deuxième surfaces, où la fente ouvre en outre dans une ouverture longitudinale (59 ; 159) le long de la surface de côté, et s'étend depuis la surface de côté le long d'une direction de profondeur (Z ; Y) transversale à la direction de traversée jusqu'à une profondeur de fente (ΔZs ; ΔYsa) dans l'élément à fentes, où la profondeur de fente est égale ou supérieure à la largeur de groupe,
où la base (62 ; 162) définit une surface interne (66) qui entoure directement le trou (65) qui ouvre dans la première surface externe, la surface interne (66) couvrant au moins une partie de la surface de côté (55, 56 ; 155, 156) et l'ouverture longitudinale (59 ; 159) de l'élément à fentes (52 ; 152), lorsque logé dans le trou,
où la première surface (53 ; 153) de l'élément à fentes (52 ; 152) est en renfoncement le long de la direction de traversée (X) par rapport à la première surface externe (63 ; 163) de la base directement autour du trou (65) qui ouvre dans la première surface externe de sorte qu'au moins la première surface de l'élément à fentes et la surface interne (66) de la base forment un réceptacle (69) logeant le corps d'étanchéification (71 ; 171), le réceptacle étant configuré initialement pour être rempli avec un matériau d'étanchéité afin de former le corps d'étanchéification, et
où le corps d'étanchéification (71 ; 171) couvre la première surface (53 ; 153) de l'élément à fentes et au moins la partie de la fente (58 ; 158) où le groupe de conducteurs de signal sort de la fente, afin d'envelopper le groupe de conducteurs de signal et de fournir une barrière hermétique entre des première et deuxième régions (21, 22) qui se tiennent à l'extérieur de l'élément à fentes et sont limitrophes des première et deuxième surfaces de l'élément à fentes respectivement.

2. L'agencement pour piste conductrice de signal (40) selon la revendication 1, où la surface de côté (55, 56 ; 155, 156) de l'élément à fentes a une forme en coupe transversale qui ressemble à un stade ou un rectangle arrondi, et où la surface interne (66) de la base autour du trou traversant a une forme en coupe transversale conçue pour loger l'élément à fentes par complémentarité de forme.

3. L'agencement pour piste conductrice de signal (40) selon la revendication 1 ou la revendication 2, où la surface de côté (55, 156 ; 155, 156) de l'élément à fentes définit une portion de surface plate (57) qui s'étend de manière symétrique en translation le long d'une direction (Y) perpendiculaire à la direction de traversée (X), où l'ouverture longitudinale (59 ; 159) est située au niveau de la portion de surface plate, et où l'au moins une fente (58 ; 158) s'étend le long de la direction de profondeur et perpendiculairement à la portion de surface plate jusque dans l'élément à fentes.

4. L'agencement pour piste conductrice de signal (40) selon l'une quelconque des revendications précédentes, où la surface de côté (55, 56 ; 155, 156) de l'élément à fentes définit un premier segment de surface de côté (55 ; 155) qui est effilé vers l'intérieur en direction d'un axe (A1) le long de la direction de traversée, et où la surface interne de la base (62 ; 162) est effilée vers l'intérieur de manière congruente au premier segment de surface de côté.

5. L'agencement pour piste conductrice de signal (40) selon la revendication 4, où la surface de côté (55, 56 ; 155, 156) de l'élément à fentes inclut un deuxième segment de surface externe (56 ; 156) qui est effilé, courbé, ou chanfreiné vers l'intérieur en direction de l'axe (A1) le long de la direction de traversée (X) mais de manière opposée par rapport au premier segment de surface de côté (55 ; 155), et/ou bien où la surface interne de la base (62 ; 162) inclut un segment de surface interne qui est effilé, courbé, ou chanfreiné vers l'extérieur à l'écart de l'axe, de telle sorte que le deuxième segment de surface de côté et/ou segment de surface interne définissent un renfoncement périphérique vers l'intérieur (70 ; 170) directement limitrophe de l'au moins une ouverture longitudinale dans l'élément à fentes, le renfoncement étant configuré pour loger une portion du corps d'étanchéification (71 ; 171).

6. L'agencement pour piste conductrice de signal (40) selon l'une quelconque des revendications précédentes, où la pluralité de conducteurs de signal (61 ; 161) est fournie comme une pluralité de fibres optiques (61), une pluralité de conducteurs électriques, et/ou comme des conducteurs (161) dans une carte de circuit imprimé (160).

7. L'agencement pour piste conductrice de signal (40) selon l'une quelconque des revendications précédentes, comprenant des conducteurs de signal (61 ; 161) supplémentaires, qui s'étendent les uns à côté des autres en réseaux afin de former des groupes de conducteurs de signal (60 ; 60i ; 160) supplémentaires avec des largeurs de groupe (Wfi) ;
où l'élément à fentes inclut des fentes supplémentaires (58i ; 158i), qui s'étendent le long de la direction de traversée à travers l'élément à fentes et ouvrent dans les première et deuxième surfaces afin de permettre aux groupes de conducteurs de signal de passer de la première surface à la deuxième surface à travers l'élément à fentes ;
où chaque fente supplémentaire ouvre dans une ouverture longitudinale (59i ; 159i) respective le long de la surface de côté, et s'étend depuis la surface de côté jusqu'à une profondeur de fente (ΔZsi ; ΔYsa) dans l'élément à fentes, et
où les ouvertures longitudinales sont fournies sur les mêmes et/ou sur des portions de surfaces plates opposées (57 ; 157) de la surface de côté de l'élément à fentes, et le corps d'étanchéification (71 ; 171) couvre toutes les fentes afin de former la barrière hermétique.

8. L'agencement pour piste conductrice de signal (40) selon l'une quelconque des revendications précédentes, où les conducteurs de signal ont un diamètre de conducteur de signal Øf et sont agencés les uns à côté des autres en un réseau à couche unique, pour former le groupe de conducteurs de signal avec une épaisseur de groupe (Hf) qui est au moins égale au diamètre de conducteur de signal mais inférieure à deux fois le diamètre de conducteur de signal.

9. L'agencement pour piste conductrice de signal (40) de la revendication 8, où la fente (58 ; 158) a une largeur de fente ΔYs ; ΔZsa transversale à la fois à la direction de traversée (X) et à la profondeur de fente (ΔZs ; ΔYsa), la largeur de fente étant comprise dans un intervalle défini par Øf < ΔYs ; ΔZsa < 2•Øf.

10. L'agencement pour piste conductrice de signal (40) selon l'une quelconque des revendications précédentes, où l'élément à fentes (52 ; 152) et la base (62 ; 162) forment des corps rigides comprenant un ou plusieurs matériaux solides, le corps d'étanchéification (71 ; 171) étant formé à partir de matériau d'étanchéité liquide qui adhère aux un ou plusieurs matériaux solides et fixe l'élément à fentes à la base une fois durci.

11. L'agencement pour piste conductrice de signal (40) selon la revendication 10, où les conducteurs de signal sont enduits d'un matériau qui est essentiellement le même que le matériau de l'élément à fentes (52 ; 152) ou d'un matériau différent du matériau de l'élément à fentes mais auquel le matériau d'étanchéité liquide adhère aussi.

12. L'agencement pour piste conductrice de signal (40) selon l'une quelconque des revendications précédentes, où le groupe de conducteurs de signal et/ou les groupes de conducteurs de signal supplémentaires comprennent un premier raccord (42 ; 142) au niveau d'une première extrémité qui est située dans la première région (21), et/ou comprennent un deuxième raccord (44 ; 144) au niveau d'une deuxième extrémité opposée qui est située dans la deuxième région (22).

13. Un système de traitement de cible (10), où le système de traitement de cible comprend une chambre à vide (20) comprenant au moins une paroi (23, 24) et l'agencement pour piste conductrice de signal (40) selon l'une quelconque des revendications précédentes fourni au niveau de ou dans la paroi, où le groupe de conducteurs de signal (60 ; 160) s'étend d'une première région (21) sur un côté de la paroi de côté à une deuxième région (22) sur un côté opposé de la paroi, via le dispositif de traversée (50 ; 150) à travers la paroi.
